# EUROPEAN PATENT APPLICATION

(11) **EP 4 707 604 A1**
(43) Date of publication of application: **11.03.2026**
(21) Application number: 25199614.6
(22) Date of filing: 02.09.2025
(51) Int. Cl.: F04D 13/06, F04D 25/06, F04D 29/00, F04D 29/58, G06F 1/20, H02K 21/24

(54) **LIQUID COOLING HEAD**

(30) Priority: 04.09.2024 TW 113209600 U
(71) Applicant: Cooler Master Co., Ltd., Taipei City 114065 (TW)
(72) Inventor: Yeh, Chiu-Yu, Taipei City (TW); Tsai, Shui-Fa, Taipei City (TW)
(74) Representative: Grünecker Patent- und Rechtsanwälte PartG mbB

(57) **Abstract**

A liquid cooling head including a housing having a gas chamber and a liquid chamber that are separated from each other, a fan blade rotatably disposed in the gas chamber, a pump impeller rotatably disposed in the liquid chamber, and a motor including a circuit board, a stator assembly, a blade rotor, and an impeller rotor, wherein the circuit board is disposed in the gas chamber, the stator assembly is disposed on the circuit board, the blade rotor and the impeller rotor are respectively disposed on the fan blade and the pump impeller, and the blade rotor and the impeller rotor are configured to generate magnetic fields with the same stator assembly to rotate the fan blade and the pump impeller.

## Description

### TECHNICAL FIELD

The present disclosure is related to the field of cooling systems for electronic devices, in particular a liquid cooling head with integrated fan and pump.

### BACKGROUND

Electronic devices, particularly high-performance computer components such as central processing units (CPUs) and graphics processing units (GPUs), generate substantial amounts of heat during operation. With the ongoing rise in processor speeds and power densities, effective thermal management is essential to maintain optimal performance, avert thermal throttling, and prevent permanent damage to delicate electronic components. A range of cooling solutions has been developed to address these thermal challenges, including air cooling systems with heat sinks and fans, liquid cooling systems, and hybrid cooling approaches that integrate various cooling technologies for enhanced heat dissipation efficiency.

Conventional liquid cooling heads with fans typically employ a straightforward approach of directly mounting existing fan assemblies to the cooling head structure. However, this conventional design approach shows numerous substantial limitations that restrict its application in practice. Since fan assemblies have their own dedicated fan motors and the cooling head have its own independent pump motor, the overall height of such fan-equipped cooling heads becomes excessive, rendering them unsuitable for installation in products with limited interior space constraints. Additionally, the dual-motor arrangement significantly increases manufacturing costs and reduces operational efficiency due to the redundancy of having separate control systems and power supplies for each motor component. These constraints necessitate a better cooling head design that can incorporate fan and pump capabilities while lowering the overall system height, cost, and complexity.

### SUMMARY

The invention is as defined in the appended claims. Aspects of the disclosure provide a liquid cooling head. The liquid cooling head can include a housing having a gas chamber and a liquid chamber that are separated from each other, a fan blade rotatably disposed in the gas chamber, a pump impeller rotatably disposed in the liquid chamber, and a motor including a circuit board, a stator assembly, a blade rotor, and an impeller rotor, wherein the circuit board is disposed in the gas chamber, the stator assembly is disposed on the circuit board, the blade rotor and the impeller rotor are respectively disposed on the fan blade and the pump impeller, and the blade rotor and the impeller rotor are configured to generate magnetic fields with the same stator assembly to rotate the fan blade and the pump impeller.

In an embodiment, the fan blade and the pump impeller have overlapping rotation axes, and the stator assembly is disposed between the blade rotor and the impeller rotor along the direction of the rotation axes. In some embodiments, the blade rotor is disposed on a side of the fan blade adjacent to the stator assembly. In some embodiments, the impeller rotor is disposed on a side of the pump impeller adjacent to the stator assembly.

In an embodiment, the housing can further include a base, an upper cover, and a separator, the base and the upper cover are coupled together to form an internal space, the separator is disposed within the internal space and secured to the base, the separator divides the internal space into the gas chamber and the liquid chamber, the fan blade is rotatably disposed on the upper cover, and the pump impeller is rotatably disposed on the separator.

In an embodiment, the upper cover can further include a central portion, a plurality of connecting portions, and a wall portion, the central portion is connected to the wall portion through the connecting portions, the fan blade is rotatably disposed on the central portion, and the wall portion is coupled with the base.

In an embodiment, the wall portion can include an annular wall body and an inner flange structure, the central portion is connected to the annular wall body of the wall portion via the connecting portions, the annual wall body has a first side and a second side, the first side of the annular wall body is coupled with the base, the inner flange structure is connected to an inner peripheral edge of the second side of the annular wall body, the inner flange structure forms an air inlet, the annular wall body includes at least one air outlet, and the air inlet and the air outlet are in communication with the gas chamber.

In an embodiment, the liquid cooling head can further include an air guide cover, wherein the air guide cover is disposed on the inner flange structure of the wall portion, the air guide cover forms an air guide opening, and the air guide opening is in communication with the air inlet.

In an embodiment, the liquid cooling head can further include a light strip, wherein the light strip is disposed within the air guide cover, the light strip has a plurality of light-emitting units, and one light-emitting surface of each light-emitting unit faces the fan blade. In an embodiment, the at least one air outlet can include a plurality of air outlets, and the air outlets are disposed at intervals along a circumferential direction of the annular wall body.

### BRIEF DESCRIPTION OF DRAWINGS

Aspects of the present disclosure can be understood from the following detailed description when read with the accompanying figures. It is noted that, in accordance with the standard practice in the industry, various features are not drawn to scale. In fact, the dimensions of the various features may be increased or reduced for clarity of discussion.
Fig. 1 is a perspective view of a liquid cooling head according to aspects of the present disclosure.
Fig. 2 is a partial exploded view of the liquid cooling head 1 as shown in Fig. 1.
Fig. 3 is an exploded view of the liquid cooling head 1 as shown in Fig. 1 from different viewing angle.
Fig. 4 is an exploded view of the liquid cooling head 1 as shown in Fig. 1 from different viewing angle.
Fig. 5 is a top view of the liquid cooling head 1 as shown in Fig. 1.
Fig. 6 is a cross-sectional view of the liquid cooling head 1 along section line A-A of Fig. 5.
Fig. 7 is a cross-sectional view of the liquid cooling head 1 along section line B-B of Fig. 5.
Fig. 8 is a cross-sectional view of the liquid cooling head 1 along section line C-C of Fig. 5.

### DETAILED DESCRIPTION

Detailed descriptions and technical contents of the present invention are illustrated below in conjunction with the accompanying drawings. However, it is to be understood that the descriptions and the accompanying drawings disclosed herein are merely illustrative and exemplary and not intended to limit the scope of the present invention.

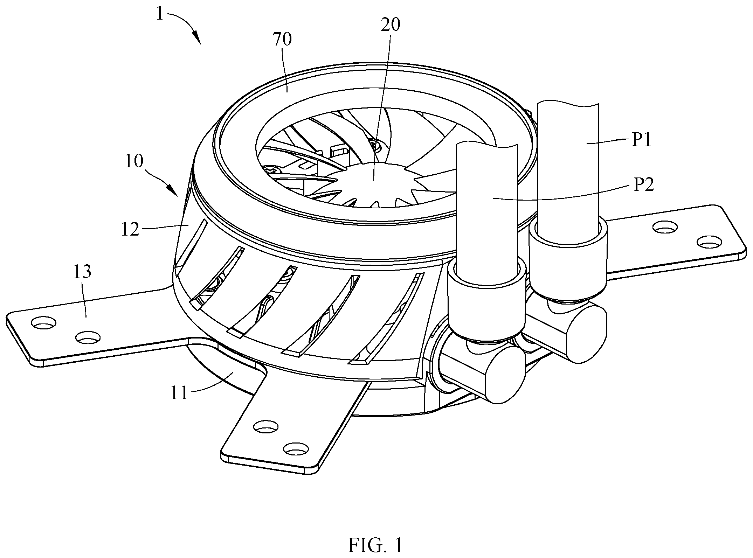

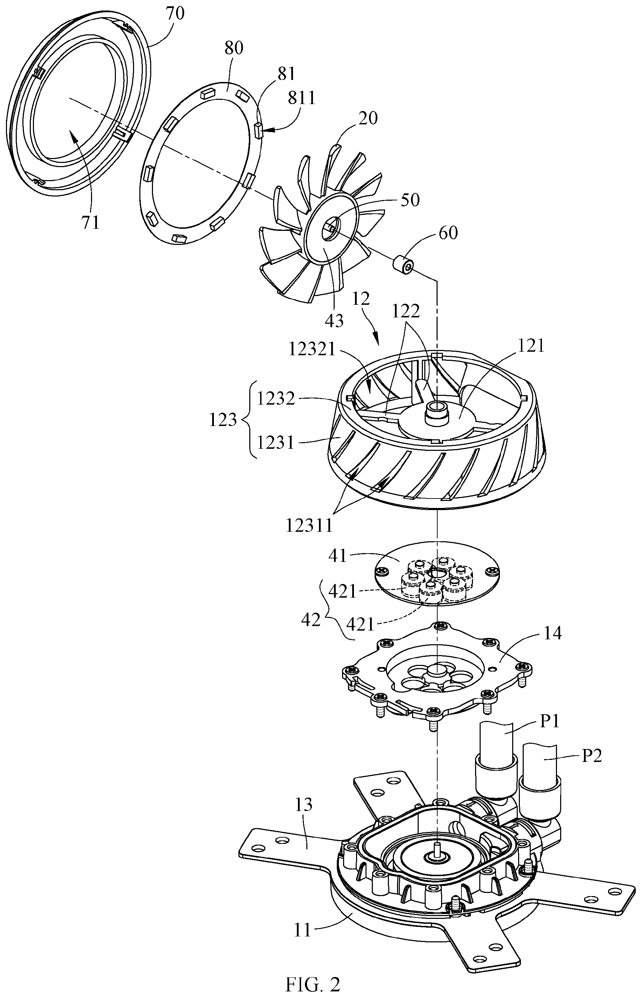

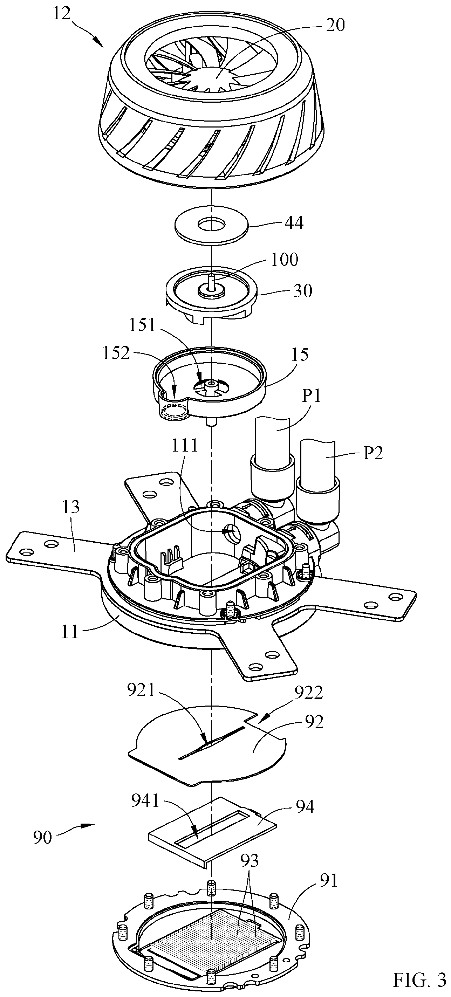

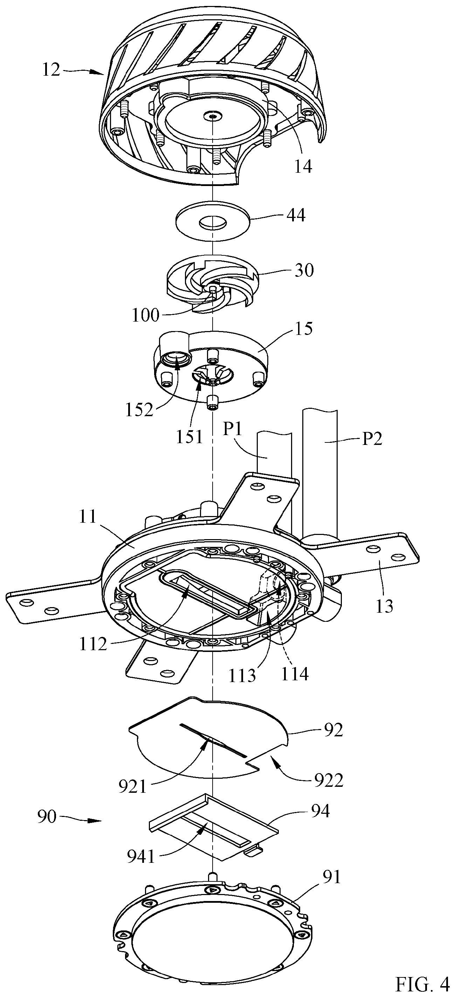

Please refer to Figs. 1 to 4. Fig. 1 is a perspective view of a liquid cooling head according to aspects of the present disclosure. Fig. 2 is a partial exploded view of the liquid cooling head 1 of Fig. 1. Figs. 3 and 4 are exploded views of another part of the liquid cooling head 1 of Fig. 1 from different viewing angles.

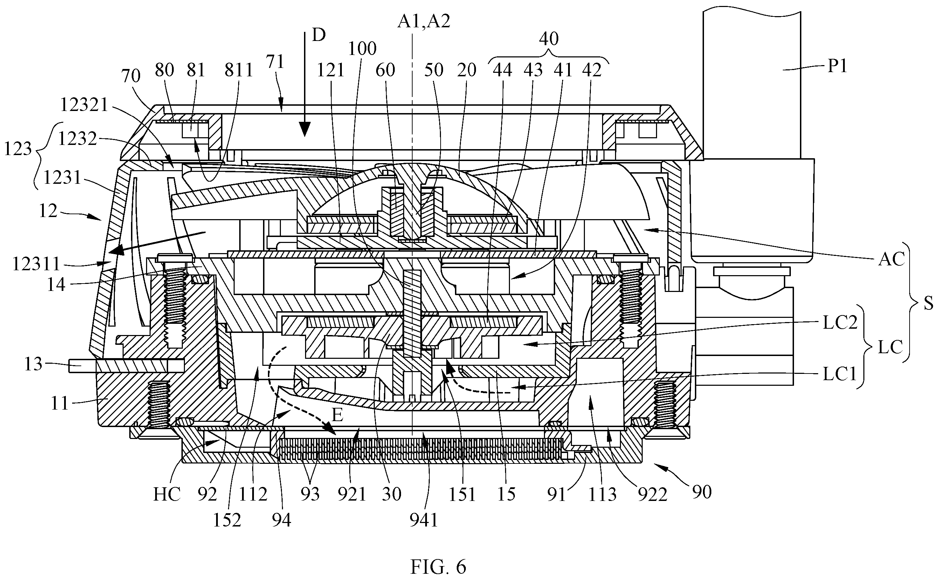

In this embodiment, the liquid cooling head 1 is configured to couple with a heat source (not shown) on a motherboard (not shown), where the heat source may be a CPU or GPU. The liquid cooling head 1 includes a housing 10, a fan blade 20, a pump impeller 30, and a motor 40 (shown in Fig. 6).

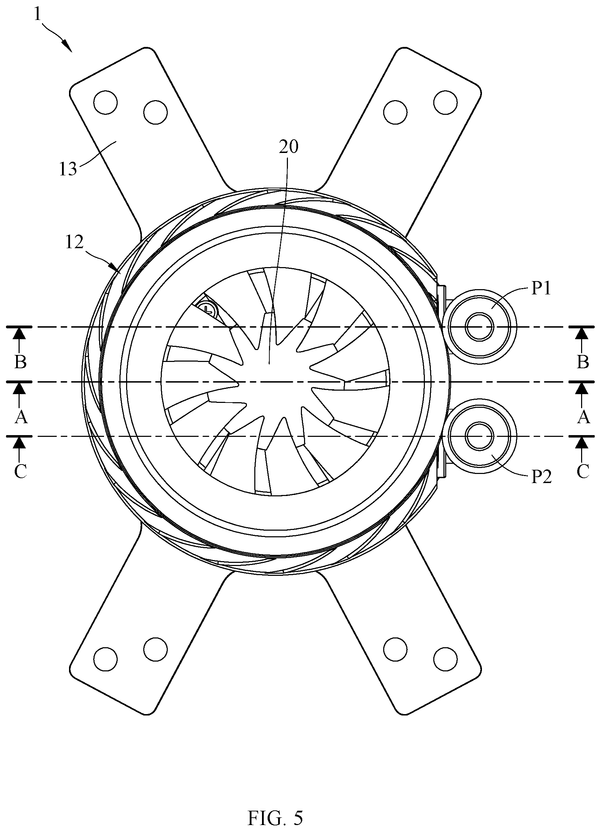

Please also refer to Figs. 5 and 6. Fig. 5 is a top view of the liquid cooling head 1 of Fig. 1. Fig. 6 is a cross-sectional view of the liquid cooling head 1 along section line A-A of Fig. 5.

The housing 10 includes a base 11, an upper cover 12, an assembly plate 13, and a first separator 14. The upper cover 12 includes a central portion 121, multiple connecting portions 122, and a wall portion 123, and the wall portion 123 includes an annular wall body 1231 and an inner flange structure 1232. The central portion 121 is connected to the annular wall body 1231 of the wall portion 123 through the connecting portions 122. One side of the annular wall body 1231 is assembled with the base 11, and the assembly plate 13 is disposed between the annular wall body 1231 and assembled with the base 11. The assembly plate 13 is configured for screws to pass through and be secured to the motherboard by screws. The inner flange structure 1232 is connected to the inner peripheral edge of the other side of the annular wall body 1231. An air inlet 12321 is formed by the inner flange structure 1232. The annular wall body 1231 includes multiple air outlets 12311, and these air outlets 12311 are arranged at intervals along the circumferential direction of the annular wall body 1231.

The base 11 and the upper cover 12 together form an internal space S that houses the primary functional components of the liquid cooling head. The first separator 14 is strategically positioned within the internal space S and securely coupled to the base 11, serving as a critical structural element that divides the internal space S into two distinct and isolated chambers: a gas chamber AC and a liquid chamber LC. This separation ensures that the liquid chamber LC and the gas chamber AC remain completely isolated, avoiding any inference between the cooling liquid and air flow systems, such as cross-contamination between the two. The air inlet 12321 and the multiple air outlets 12311 are specifically configured to be in direct communication with the gas chamber AC, establishing a dedicated air flow path that enables efficient ventilation and cooling of the motor components housed within the gas chamber. The number and position of air outlets 12311 can be varied according to specific design requirements and thermal management needs, with configurations ranging from a single outlet to multiple outlets strategically arranged around the annular wall body 1231 to optimize air flow distribution and cooling performance.

The liquid cooling head 1 may further include a first pivot shaft 50, a bearing 60, an air guide cover 70, and a light strip 80. The fan blade 20 is, for example, an axial flow blade. The fan blade 20 is rotatably mounted on the central portion 121 of the upper cover 12 via the first pivot shaft 50 and the bearing 60. The air guide cover 70 is coupled to the inner flange structure 1232 of the wall portion 123 of the upper cover 12, forming an aerodynamically optimized air flow path. An air guide opening 71 formed by the air guide cover 70 maintains direct communication with the air inlet 12321, effectively channeling and directing external air flow toward the air inlet 12321 for entry into the gas chamber AC. The system further includes an optional light strip 80 positioned within the air guide cover 70, featuring multiple light-emitting units 81 such as light-emitting diodes (LEDs). These light-emitting units 81 are strategically oriented with their light-emitting surfaces 811 facing the fan blade 20, enabling the projection of illumination onto the rotating fan blade 20 to create visually appealing lighting effects that enhance the aesthetic appeal of the cooling system.

It should be noted that the air guide cover 70 and the light strip 80 are optional components and may be necessary in some embodiments.

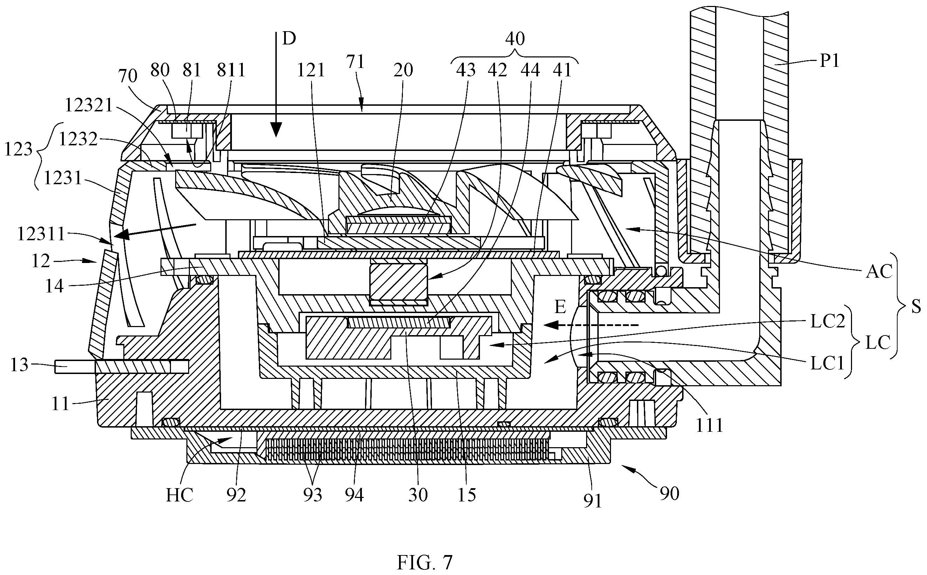

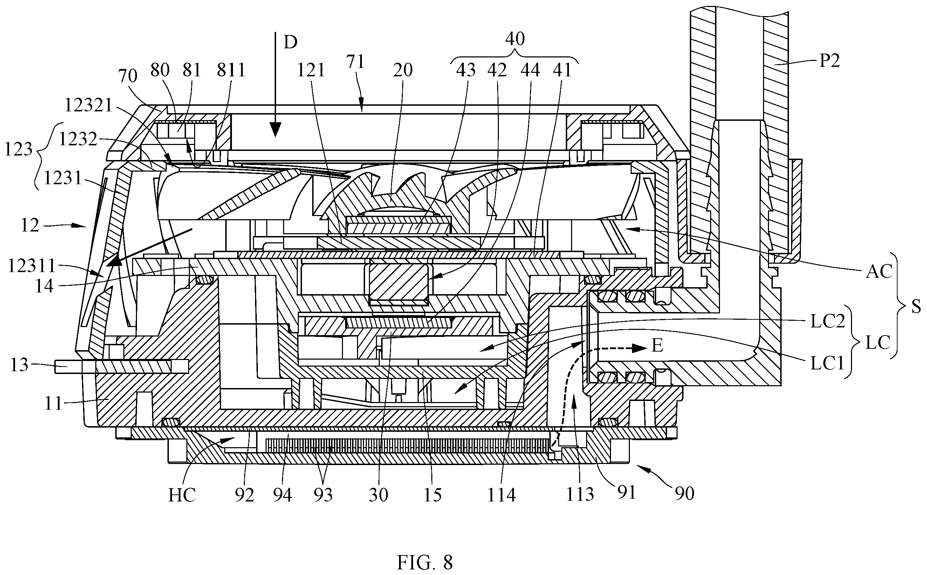

Please further refer to Figs. 3 to 8. Fig. 7 is a cross-sectional view of the liquid cooling head 1 along section line B-B of Fig. 5. Fig. 8 is a cross-sectional view of the liquid cooling head 1 along section line C-C of Fig. 5.

The housing 10 may further include a second separator 15. The second separator 15 is disposed within the liquid chamber LC and secured to the base 11. The second separator 15 divides the liquid chamber LC into a first chamber LC1 and a second chamber LC2, where the second chamber LC2 is disposed between the first chamber LC1 and the gas chamber AC. The base 11 includes a liquid inlet 111, a first connecting channel 112, a second connecting channel 113, and a liquid outlet 114. The second separator 15 includes a first opening 151 and a second opening 152. The liquid inlet 111 of the base 11 is in communication with the first chamber LC1. The first chamber LC1 is in communication with the second chamber LC2 through the first opening 151 of the second separator 15. The second chamber LC2 is in communication with the first connecting channel 112 of the base 11 through the second opening 152. The second connecting channel 113 of the base 11 is in communication with the liquid outlet 114.

The liquid cooling head 1 may further include a heat conducting box 90. The heat conducting box 90 includes a base body 91, a cover plate 92, multiple fin structures 93, and a flow blocking member 94. The cover plate 92 and the base body 91 together form a heat exchange chamber HC. The fin structures 93 are disposed within the heat exchange chamber HC and thermally coupled to the base body 91. The flow blocking member 94 is disposed within the heat exchange chamber HC and between the cover plate 92 and the fin structures 93. The cover plate 92 has an inlet 921 and an outlet 922, and the flow blocking member 94 has a communication opening 941. The inlet 921 of the cover plate 92 is in communication with the heat exchange chamber HC through the communication opening 941, while the outlet 922 of the cover plate 92 is directly in communication with the heat exchange chamber HC. The base body 91 of the heat conducting box 90 is fixed to the base 11, such that the first connecting channel 112 of the base 11 is in communication with the heat exchange chamber HC through the inlet 921 of the cover plate 92 and the communication opening 941 of the flow blocking member 94, and the outlet 922 of the cover plate 92 is in communication with the liquid outlet 114 through the second connecting channel 113 of the base 11.

The base body 91 of the heat conducting box 90 is configured to thermally couple with the heat source of the motherboard to conduct heat generated by the heat source to the fin structures 93. Additionally, the liquid inlet 111 and the liquid outlet 114 of the base 11 are respectively connected to pipe fittings P1 and P2. The pipe fitting P1 can deliver coolant to the first chamber LC1 through the liquid inlet 111. The coolant then flows through the first opening 151 of the second separator 15, the second chamber LC2, the second opening 152 of the second separator 15, the first connecting channel 112 of the base 11, the inlet 921 of the cover plate 92, and the communication opening 941 of the flow blocking member 94 into the heat exchange chamber HC for heat exchange with the fin structures 93. The heated coolant then flows through the outlet 922 of the cover plate 92 into the second connecting channel 113 of the base 11. Then, the heated coolant flows out of the liquid cooling head 1 through the liquid outlet 114 and the pipe fitting P2 to a radiator (not shown) for cooling. Subsequently, the coolant returns to the liquid cooling head 1 to repeat the above flow process.

It should be noted that the heat conducting box 90 is an optional component. In some embodiments, the liquid cooling head may not include a heat conducting box. In such configurations, the first connecting channel of the base can be directly in communication with the second connecting channel.

The liquid cooling head 1 may further include a second pivot shaft 100. The pump impeller 30 is rotatably disposed on the first separator 14 and the second separator 15 within the second chamber LC2 through the second pivot shaft 100. The rotation axis A2 of the pump impeller 30 overlaps with the rotation axis A1 of the fan blade 20.

The motor 40 includes a circuit board 41, a stator assembly 42, a blade rotor 43, and an impeller rotor 44. The circuit board 41 is located within the gas chamber AC and secured to the first separator 14. The circuit board 41 is electrically connected to the motherboard, for example, through wires plugged into slots on the motherboard, so that the mother board could control the circuit board 41. The stator assembly 42 includes multiple coils 421, and the coils 421 are disposed on the circuit board 41 on a side facing the pump impeller 30. The blade rotor 43 and the impeller rotor 44 are, for example, magnets. The blade rotor 43 and the impeller rotor 44 are respectively disposed on the fan blade 20 and the pump impeller 30. In a direction parallel to the rotation axis A1 of the fan blade 20 and the rotation axis A2 of the pump impeller 30, the stator assembly 42 is disposed between the blade rotor 43 and the impeller rotor 44. The blade rotor 43 is disposed on a side of the fan blade 20 facing the stator assembly 42, and the impeller rotor 44 is disposed on a side of the pump impeller 30 facing the stator assembly 42. This present motor configuration forms an integrated dual-drive system where a single stator assembly can simultaneously control both the fan blade and pump impeller with their respective rotors.

Furthermore, the operation of the liquid cooling head 1 will be described. In Figs. 6 to 8, direction E with dashed arrows represents the direction of coolant flow, while direction D with solid arrows represents the direction of air flow. Upon energization of the stator assembly 42, a magnetic field is generated between the impeller rotor 44 and the stator assembly 42, enabling the pump impeller 30 to rotate, while a magnetic field is also formed between the blade rotor 43 and the stator assembly 42, leading to the rotation of the fan blade 20. The rotating pump impeller 30 can drive the coolant entering the liquid cooling head 1 to flow through the heat exchange chamber HC, allowing the coolant to exchange heat with the fin structures 93 and carry away the heat generated by the heat source. The rotating fan blade 20 can draw external cold air from the air guide opening 71 and the air inlet 12321 into the gas chamber AC. This facilitates the circulation of the external cold air cross the circuit board 41 and the stator assembly 42 for their cooling. Subsequently, the air can flow out of the gas chamber AC through the air outlets 12311, facilitating the cooling of electronic components on the motherboard.

With such arrangements and operations, the fan blade 20 and the pump impeller 30 can be rotated through the use of the same stator assembly 42 and circuit board 41. This is beneficial for reducing the overall height of the liquid cooling head 1, minimizing the cost of the liquid cooling head 1, and enhancing the operational efficiency of the liquid cooling head 1. Specifically, when compared to conventional methods of directly attaching existing fans onto cooling heads, the present liquid cooling head 1 can achieve a height reduction of approximately 25%, resulting in a significant space saving benefit for applications with limited internal clearance. The operational efficiency can be enhanced by approximately 15% due to the elimination of redundant motor systems and the optimization of electromagnetic coupling between the shared stator assembly and dual rotors. Furthermore, the cost savings can be achieved t by eliminating one complete set of circuit board and stator assembly components that would otherwise be required in conventional dual-motor configurations, lowering both material costs and manufacturing complexity while maintaining superior cooling performance.

The shared motor configuration provides significant design flexibility and modularity advantages that extend beyond conventional cooling systems. Since the rotation of the fan blade 20 and the pump impeller 30 is accomplished via a unified control system utilizing the same stator assembly 42 and circuit board 41, the fan blade 20 can be replaced independently to meet specific application requirements without requiring changes to the motor or pump components. This modular design approach enables the adoption of numerous fan blade types optimized for different cooling scenarios, including but not limited to centrifugal fan blades. The electromagnetic coupling between the blade rotor 43 and the stator assembly 42 would remain constantly stable regardless of the fan blade arrangement, ensuring that new fan blades as replacements are fully compatible with the existing motor system. This interchangeability feature allows system designers and end users to optimize cooling performance for specific thermal loads, space constraints, or acoustic requirements without having to replace entire system or make significant changes to the underlying cooling infrastructure.

The shared stator assembly 42 and circuit board 41 configuration enables synchronized control, which provides sophisticated thermal management optimization, significantly decreasing power consumption waste and simplifying system control complexity. Furthermore, the unified motor control system allows for precise coordination between the rotational speeds of the fan blade 20 and the pump impeller 30, allowing dynamic performance scaling based on real-time thermal demands. For example, when the heat source, such as a CPU, operates under reduced computational load and generates lower heat, the motherboard's control system can intelligently reduce the power supplied to the motor 40, thereby decreasing the rotational speed of the pump impeller 30 in correspondence to the reduced cooling requirements. Simultaneously, the rotational speed of the fan blade 20 decreases proportionally, maintaining optimal cooling efficiency for the motor components while avoiding unnecessary power consumption associated with conventional independent motor systems. This synchronized speed control eliminates the inefficiencies associated with mismatched cooling component speeds, preventing circumstances in which one cooling element operates at unnecessarily high speeds while others remain underutilized. The coordinated control system also significantly minimizes the computational overhead and control circuit complexity necessary to manage conventional separate motor systems, while ensuring more predictable and reliable cooling performance under fluctuating thermal load circumstances. Additionally, the synchronized operation ensures consistent electromagnetic loading on the stator assembly 42, hence enhancing motor longevity and reliability in contrast to conventional systems with independently controlled motors that may encounter fluctuating electromagnetic pressures.

Moreover, compared to the conventional method of using magnets to drive the pump impeller 30 to rotate under existing fan architectures, the configuration where the fan blade 20 and the pump impeller 30 share the same stator assembly 42 and circuit board 41 to achieve synchronized rotational speeds can prevent load escalation, minimize discrepancies in rotational speeds between the fan blade 20 and the pump impeller 30, and mitigate the issue of the pump impeller 30 failing to rotate due to increased rotational resistance from driving liquid.

Additionally, since the rotation of the fan blade 20 and the pump impeller 30 is achieved by sharing the same stator assembly 42 and circuit board 41, only one slot on the motherboard is required for connecting the wires plugged into the circuit board 41. Therefore, compared to the conventional configuration, where existing fans and cooling heads are still required for two slots on the motherboard after assembly, the liquid cooling head 1 of this embodiment can minimize the number of slots occupied on the motherboard.

The stator assembly 42 is positioned between the blade rotor 43 and the impeller rotor 44, in a direction parallel to the rotation axis A1 of the fan blade 20 and the rotation axis A2 of the pump impeller 30, and it maintains air gaps between the blade rotor 43 and between the impeller rotor 44, thereby defining an axial air gap motor 40. This axial air gap motor 40 can drive both the pump impeller 30 and the fan blade 20. The driven fan blade 20 can cool the stator assembly 42 and the circuit board 41 of the motor 40, hence prolonging the motor 40's lifespan. Furthermore, when the liquid cooling head 1 is secured to the motherboard and thermally coupled to a heat source, such as a CPU, the fan blade 20 can concurrently provide cooling for surrounding electronic components on the motherboard, thereby establishing a comprehensive thermal management solution that addresses both primary heat source cooling and auxiliary component thermal protection. This dual-function feature eliminates the need for extra cooling fans around the cooling head, lowering the system's overall component count and associated manufacturing costs.

The axial magnetic force generated by the motor 40 keeps the impeller rotor 44 at a constant horizontal position during operation, effectively preventing vertical displacement or floating motion of the pump impeller 30, which would otherwise cause mechanical noise and vibration. This steady orientation eliminates the need for extra mechanical stabilization components or precision bearing systems that would increase manufacturing complexity and cost. The consistent rotor position also diminish wear on bearing surfaces and mechanical interfaces, hence prolonging the operational lifespan of the cooling system and minimizing maintenance requirements. Furthermore, the reduced noise generation eliminates the need for additional sound dampening materials or specialized housing designs to meet acoustic performance specifications, lowering material costs and manufacturing complexity while offering a better user experience.

The present liquid cooling head provides comprehensive cooling solutions through the integration of shared motor control and dual cooling mechanisms. The motor's stator assembly is disposed on the circuit board, with the blade rotor and the impeller rotor respectively disposed on the fan blade and the pump impeller Both the blade rotor and the impeller rotor capable generate magnetic fields utilizing the same stator assembly to facilitate the rotation of the fan blade and the pump impeller, thereby enhancing thermal performance via multiple synergistic mechanisms. The shared stator assembly and circuit board configuration provides precise thermal load balancing between liquid and air cooling systems, allowing dynamic optimization of cooling efficiency according to real-time thermal conditions. The integrated design eliminates thermal bottlenecks, which are frequent in conventional systems where separate motor assemblies generate additional heat loads that must be managed individually. Furthermore, the unified electromagnetic system runs more efficiently due to better magnetic field utilization, reducing parasitic power losses and heat generation inside the motor assembly. The advantages of the system integration include simpler thermal interface management, as the single motor assembly requires only one thermal management strategy rather than multiple independent cooling systems for individual fan and pump motors. This integration also allows for more sophisticated thermal control algorithms that can simultaneously optimize both liquid circulation rates and air flow volumes based on comprehensive system thermal feedback, resulting in superior overall cooling performance while reducing the overall height of the liquid cooling head, lowering manufacturing costs, and improving operational efficiency when compared to conventional multi-motor cooling systems.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope the appended claims.

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. A liquid cooling head (1), comprising:
a housing (10) having a gas chamber (AC) and a liquid chamber (LC) that are separated from each other;
a fan blade (20) rotatably disposed in the gas chamber (AC);
a pump impeller (30) rotatably disposed in the liquid chamber (LC); and
a motor (40) including a circuit board (41), a stator assembly (42), a blade rotor (43), and an impeller rotor (44),
wherein the circuit board (41) is disposed in the gas chamber (AC), the stator assembly (42) is disposed on the circuit board (41), the blade rotor (43) and the impeller rotor (44) are respectively disposed on the fan blade (20) and the pump impeller (30), and the blade rotor (43) and the impeller rotor (44) are configured to generate magnetic fields with the same stator assembly (42) to rotate the fan blade (20) and the pump impeller (30).

2. The liquid cooling head (1) of claim 1, wherein the fan blade (20) and the pump impeller (30) have overlapping rotation axes (A1, A2), and the stator assembly (42) is disposed between the blade rotor (43) and the impeller rotor (44) along the direction of the rotation axes (A1, A2).

3. The liquid cooling head (1) of claim 2, wherein the blade rotor (43) is disposed on a side of the fan blade (20) adjacent to the stator assembly (42).

4. The liquid cooling head (1) of claim 2, wherein the impeller rotor (44) is disposed on a side of the pump impeller (30) adjacent to the stator assembly (42).

5. The liquid cooling head (1) of claim 1, wherein the housing (10) further includes a base (11), an upper cover (12), and a separator (14), the base (11) and the upper cover (12) are coupled together to form an internal space (S), the separator (14) is disposed within the internal space (S) and secured to the base (11), the separator (14) divides the internal space (S) into the gas chamber (AC) and the liquid chamber (LC), the fan blade (20) is rotatably disposed on the upper cover (12), and the pump impeller (30) is rotatably disposed on the separator (14).

6. The liquid cooling head (1) of claim 5, wherein the upper cover (12) further includes a central portion (121), a plurality of connecting portions (122), and a wall portion (123), the central portion (121) is connected to the wall portion (123) through the connecting portions (122), the fan blade (20) is rotatably disposed on the central portion (121), and the wall portion (123) is coupled with the base (11).

7. The liquid cooling head (1) of claim 6, wherein the wall portion (123) includes an annular wall body (1231) and an inner flange structure (1232), the central portion (121) is connected to the annular wall body (1231) of the wall portion (123) via the connecting portions (122), the annual wall body (1231) has a first side and a second side, the first side of the annular wall body (1231) is coupled with the base (11), the inner flange structure (1232) is connected to an inner peripheral edge of the second side of the annular wall body (1231), the inner flange structure (1232) forms an air inlet (12321), the annular wall body (1231) includes at least one air outlet (12311), and the air inlet (12321) and the air outlet (12311) are in communication with the gas chamber (AC).

8. The liquid cooling head (1) of claim 7, further comprising an air guide cover (70), wherein the air guide cover (70) is disposed on the inner flange structure (1232) of the wall portion (123), the air guide cover (70) forms an air guide opening (71), and the air guide opening (71) is in communication with the air inlet (12321).

9. The liquid cooling head (1) of claim 8, further comprising a light strip (80), wherein the light strip (80) is disposed within the air guide cover (70), the light strip (80) has a plurality of light-emitting units (81), and one light-emitting surface (811) of each light-emitting unit (81) faces the fan blade (20).

10. The liquid cooling head (1) of claim 7, wherein the at least one air outlet includes a plurality of air outlets (12311), and the air outlets (12311) are disposed at intervals along a circumferential direction of the annular wall body (1231).
